Europäisches Patentamt

European Patent Office

Office européen des brevets

(11) Publication number: **0 184 328**
A1

# (12) EUROPEAN PATENT APPLICATION

(21) Application number: **85308014.1**

(22) Date of filing: **04.11.85**

(51) Int. Cl.⁴: **H 05 K 5/00**
**G 02 B 6/04**

(30) Priority: **05.11.84 GB 8427939**

(43) Date of publication of application:
**11.06.86 Bulletin 86/24**

(84) Designated Contracting States:
**DE FR GB IT**

(71) Applicant: **BARRY WRIGHT CORPORATION**
**1 Newton Executive Park**
**Newton Lower Falls Massachusetts 02162(US)**

(72) Inventor: **Radford, Michael Harold**
**12 Cunningham Avenue Boxgrove Park**
**Guildford Surrey GU1 2PE(GB)**

(74) Representative: **Abrams, Michael John et al,**
**HASELTINE LAKE & CO. Hazlitt House 28 Southampton**
**Buildings Chancery Lane**
**London WC2A 1AT(GB)**

(54) Improvements relating to trays for mounting electrical or electronic units.

(57) A tray (1) for mounting an electrical or electronic unit is disclosed which tray includes an optical circuit including two light guides, e.g. optic fibres (6; 7), disposed such that, when the electrical or electronic box is correctly mounted on the tray, the optical configuration of said two light guides is in a first state, while when an electrical or electronic box is incorrectly mounted in the tray, the optical configuration of said two light guides is in a second state distinguishable from said first state. There may be a mechanical device, e.g. a blade (10; 18), mounted between the light guides so that the device is moved by the action of inserting an electrical or electronic unit into the tray. Alternatively, the light guides may be moved directly relative to one another by the action of inserting the unit.

Fig.1.

# IMPROVEMENTS RELATING TO TRAYS FOR MOUNTING
## ELECTRICAL OR ELECTRONIC UNITS

This invention relates to trays for mounting electrical or electronic units and in particular (but not exclusively) to avionics trays. More particularly, the invention is concerned with a method of, and means for, determining whether a box (i.e. an electrical or electronics unit having a plurality of pin connectors) is properly mounted in the tray, e.g. an avionics tray.

Electrical and electronic equipment is frequently assembled into boxes with electrical pin connectors on their rear faces. When installed for example in aircraft or military vehicles, such boxes are conventionally positioned on a mounting tray and held in place by mechanical means. The pin connectors on such boxes mate with a connector plate fixed at one end of the mounting tray. Generally, the action of inserting the box serves to mate the connector pins with the connector plate. It is important to ensure that the two connector parts (i.e. the pins on the box and the plate attached to the tray) are adequately mated in order to achieve the necessary electrical circuit without over compression of the relatively delicate connector pins. This poses a problem, since typically the pins and connector plate are out of sight when the connection is effected. It is known to use a mechanical inserter/extractor device which may, for example, have a torque limiting arrangement which permits only a given amount of thrust to be applied to the pin connectors. Some known inserter/extractor units have an indicator device which serves to indicate when the box is properly mounted in the tray. Such systems, however, are not infallible since there is always the possibility that some form of obstruction may have accidentally become lodged between the rear of the box and the connector plate. In such circumstances, the torque limit may be achieved without adequate contact between connector pins and connector plate; hence a torque-dependent indicator device would falsely indicate that the box was properly mounted. This could be dangerous and it is accordingly desirable to have some means for giving a more accurate indication of whether a box is correctly mounted.

According to the present invention, there is provided a tray for mounting an electrical or electronic unit, which tray includes an optical circuit including two light guides disposed such that, when the electrical or electronic box is correctly mounted on the tray, the optical configuration of said two light guides is in a first state, while when an electrical or electronic box is incorrectly mounted in the tray, the optical configuration of said two light guides is in a second state distinguishable from said first state.

Preferably, the two light guides are disposed such that, when a box is correctly mounted on the tray, said two light guides are in optical communication with one another, while in the absence of a box, or when a box is incorrectly mounted on the tray, the two light guides are not in optical communication with one another.

The optical circuit is preferably arranged to allow an input to one of said two light guides, and to permit observation of the presence or absence of light in the other of said two light guides.

The two light guides are preferably optic fibres. Conveniently, the optic fibres may be affixed to part of the tray close to the base thereof, one end of both of the optic fibres being located at the rear of the tray in the vicinity of the connector plate. These ends of the optic fibres can be positioned close to one another so that mounting of an electrical or electronic box on the tray causes the ends of the fibres either to come into alignment, or to move out of alignment, as the case may be. Thus the action of correctly inserting a box will result in the optical circuit changing from one state to another state.

In one embodiment, the tray includes a mechanical device interposed between the ends of the optic fibres such that it can make or break the optical communication between the two fibres. Such a mechanical device may, for example, be a perforated or slotted blade positioned between opposing ends of the two optic fibres. The movement of the blade may be a simple linear to-and-fro motion or it may be a pivotal motion, e.g. a toggle motion. Such a blade is preferably non-reflective and is conveniently sprung-loaded so that, when a box is not mounted on the tray with the proper electrical connection being made, the blade is held in a position preventing optical communication between the optic fibres, whereas when a correct mounting and electrical connection is achieved, optical communication between the optic fibres is possible through the slot or perforation in the blade. Hence correct mounting of a box is indicated by optical communication between the two fibres, while conversely an incorrect mounting means that there is no optical communication. It will be appreciated that the opposite mode (i.e. breaking of optical communication when correct mounting is achieved) is possible, but this mode is not preferred.

In another embodiment, the blade may be stationary and the relative movement between connector pins and connector plate may be transmitted to one or both of the optic fibres.

Where the system uses a blade such as just described, this is preferably part of a unit which can be inserted into an appropriately shaped slot in the tray, e.g. in the base close to the rear end thereof or in the end of the tray itself.

In a further embodiment, the optic fibres may be placed out of line or at an angle with respect to one another, optical communication between the two fibres being achieved by a reflective surface which is moved into the appropriate configuration by the action of correclty inserting a box onto the tray. This embodiment is not preferred, however, because of the difficulty in ensuring precise alignment of the relfective surface in order to give satisfactory optical communication between the two optic fibres.

In yet another embodiment, one end of one of the optic fibres may be mounted in a shoe positioned on one end of a leaf spring, the other end of the leaf spring being secured to the tray in the vicinity of the connector plate. Correct mounting of an electrical or electronic box causes pressure on the shoe which moves to change the optical configuration between the two optic fibres. The leaf spring acts as a biassing element to restore the original position of said one optic fibre when the box is removed or is improperly mounted.

Generally, the non-cooperating ends of the two optic fibres will be located at the front end of the tray – that is, at that end of the tray remote from the connector plate. The two optic fibres may conveniently be attached along the exterior of the side flanges of the tray. Means for introducing light into one of the optic fibres may be included, but this is not necessary since in general the front end of a tray such as an avionics tray is readily accessible and thus a simple device such as a torch may be used to introduce light into said one of the optic fibres. Similarly, a light-detecting unit may be incorporated into the optical circuit so as to detect the presence or absence of light in the other of the two optic fibres. This, however, is not essential when the second optic fibre terminates close to the front end of the tray. In these circumstances, visual inspection will give a sufficient indication of whether or not optical communication exists between the two fibres.

If desired, lenses may be used at the ends of the two optic fibres in order to enhance visibility. If desired, such lenses may be coloured.

Where there is a blade positioned between the co-operating ends of the optic fibres, the blade surfaces are preferably matt black. They may alternatively be coloured, so that a limited degree of reflection can occur when the blade is obstructing optical communication between the two fibres: this permits visual indication that the blade is disposed between the two fibres.

The invention will now be described, by way of example, with reference to the accompanying drawings, in which:

FIGURE 1 shows a schematic perspective view of a typical avionics tray incorporating features in accordance with the present invention;

FIGURES 2 and 3 illustrate the mode of operation of part of the apparatus shown in Figure 1;

FIGURES 4a-d are schematic sectional views inside elevation of alternative embodiments of the part shown in Figures 2 and 3;

FIGURE 5 is an enlarged perspective view of a further embodiment of the part illustrated in Figures 2 and 3;

FIGURE 6 is a schematic plan view of the part shown in Figure 5; and

FIGURE 7 is a schematic plan view of a further embodiment of the invention.

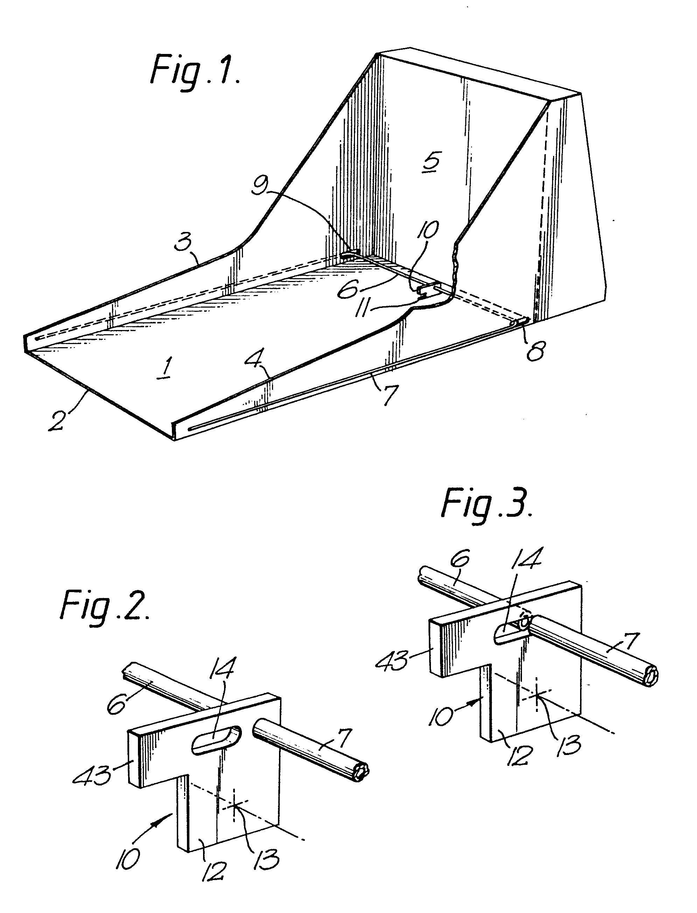

Referring now to Figure 1 of the drawings, an avionics tray includes a base plate 1, having a front edge 2 and secured to upwardly extending lateral flanges 3 and 4. The rear end of the avionics tray includes a surface 5 which carries a connector plate (not shown) adapted to receive the connector pins of an electronic unit or box (not shown).

The tray includes an optical circuit comprising a first light guide 6 and a second light guide 7. In this embodiment, light guides 6 and 7 are constituted by optic fibres. The two fibres 6 and 7 are secured to lateral flanges 3 and 4, respectively, and pass through slots 8 and 9 to the inner part of the tray. A blade 10 is interposed between the ends of fibres 6 and 7. Blade 10 is mounted in a slot 11 formed in the base of tray 1 close to rear surface 5. The blade is positioned in relation to the connector plate (not shown) for receiving the connector pins of an electrical or electronic unit such that insertion of the pins into the female connector plate results in blade 10 being moved towards rear face 5. Blade 10 is provided with biassing means (not shown in Figure 1) which urges the blade away from rear face 5 when allowed to do so by the relative position between the electronic unit carrying the connector pins and the connector plates.

Referring now to Figures 2 and 3, there is shown one constructional embodiment of blade 10 in two different positions. In this embodiment, the blade comprises a body section 12 pivotally mounted at 13 in slot 11 (see Figure 1). The surface of body portion 12 is matt black and has a very low reflectivity. A shoulder 43 extends forwardly (with respect to rear face 5) of body portion 12. The upper part of blade 10 includes a slot 14. In the configuration shown in Figure 2, optic fibres 6 and 7 cannot communicate optically with one another since the body of blade 10 is interposed between their opposing ends. In the configuration as shown in Figure 3, blade 10 has been rotated about pivot 13 in a clockwise sense as seen in the drawings, to an extent sufficient to enable optical communication between fibres 6 and 7 to occur through slot 14. Pivotal movement of blade 10 results from the action of an incoming electronic unit pressing against shoulder 43. Biassing means (not shown in Figures 2 and 3) is provided in association with blade 10 to ensure that, when the unit is removed, blade 10 is pivoted in a counter-clockwise sense so as to restore it to the configuration shown in Figure 2.

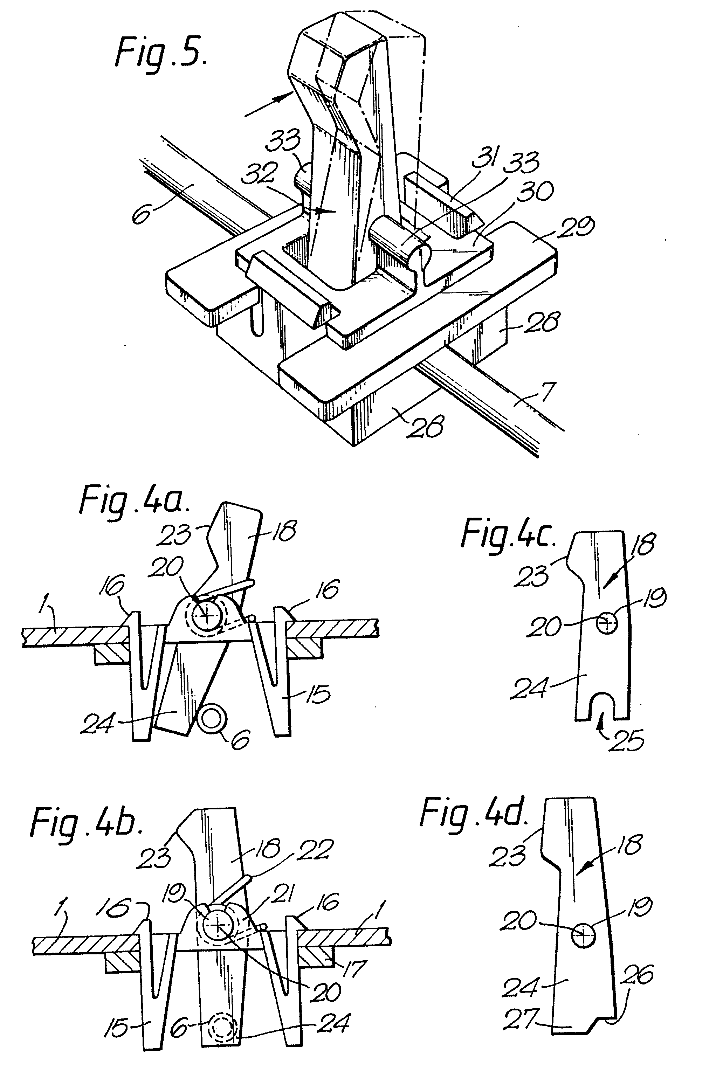

A further embodiment of blade 10 is illustrated in Figure 4. In this embodiment, the blade is in the form of a snap-in unit for insertion into a slot such as slot 11 (see Figure 1) formed in base plate 1 of the avionics tray. Unlike the arrangement shown in Figure 1, however, the blade unit illustrated in Figure 4 is intended for use with a tray in which optic fibres 6 and 7 are located, in the vicinity of rear face 5, beneath base plate 1 of the tray. It will be appreciated that such a construction differs from that of Figure 1 only in minor respects. As shown in Figures 4a and 4b, the unit comprises a resilient framework 15 having retaining lugs 16 arranged so that when the unit is inserted from beneath the base plate 1, lugs 16 snap over the edges of slot 11 and hold the unit tightly with respect to the tray 1. The unit includes a planar member 17 which abuts against the undersurface of tray 1 when the blade unit is in position. The blade proper comprises an upright member 18 including lateral projections 19 which define a pivot axis 20. Lateral projections or arms 19 are engaged in a slot formed in a member 21 which itself is secured to framework 15. A biassing member in the form of a spring 22 (a coil spring in the illustrated embodiment but alternatively a leaf spring) is located about one of arms 19 and urges blade member 18 to pivot in a counter-clockwise direction about pivot axis 20. The upper part of blade member 18 includes a shoulder 23 which co-operates with the rear face of an incoming electronic unit so as to alter the optical configuration of the two optic fibres 6 and 7. The configuration shown in Figure 4a is that in which the electronic unit (not shown) has been correctly inserted so that its connector pins mate with the connector plate (not shown) adjacent to rear face 5 of tray 1 (see Figure 1), without the electronic unit being over-compressed. The lower end 24 of blade member 18 moves, as a result of the pivoting action about axis 20, to a position in which the ends of optic fibres 6 and 7 confront one another, thereby permitting optical communication between them.

When the electronic unit is removed, coil spring 22 urges blade member 18 back into the position shown in Figure 4b, where the lower portion 24 of blade member 18 is interposed between the ends of fibres 6 and 7, thereby preventing optical communication between these fibres. The lower portion 24 of blade member 18 may if desired be coloured - e.g. coloured red - so that a positive indication of the blade position may be observed by inspection via one or other of optic fibres 6 and 7.

A variant construction of blade member 18 is shown in Figure 4c. In this variant, the lower part 24 of blade member 18 is bifurcated, so that at its bottom end there is a recess 25. This recess is such that, when the blade unit is in the configuration shown in Figure 4b, optical fibres 6 and 7 are aligned with recess 25, thus permitting optical communication between them. When the blade 18 is moved to the configuration as shown in Figure 4a, recess 25 is no longer aligned with optic fibres 6 and 7 and consequently optical communication between these two fibres is prevented.

Figure 4d shows yet another variant of blade member 18. In this variant, the lower portion 24 of blade member 18 has a cutaway region 26. When the blade member is in the configuration as shown in Figure 4a, cutaway portion 26 permits optical communication between fibres 6 and 7. When the restoring force of coil spring 22 brings blade member 18 back to the configuration shown in Figure 4b, the lowermost portion 27 of blade member 18 obstructs optical communication between fibres 6 and 7.

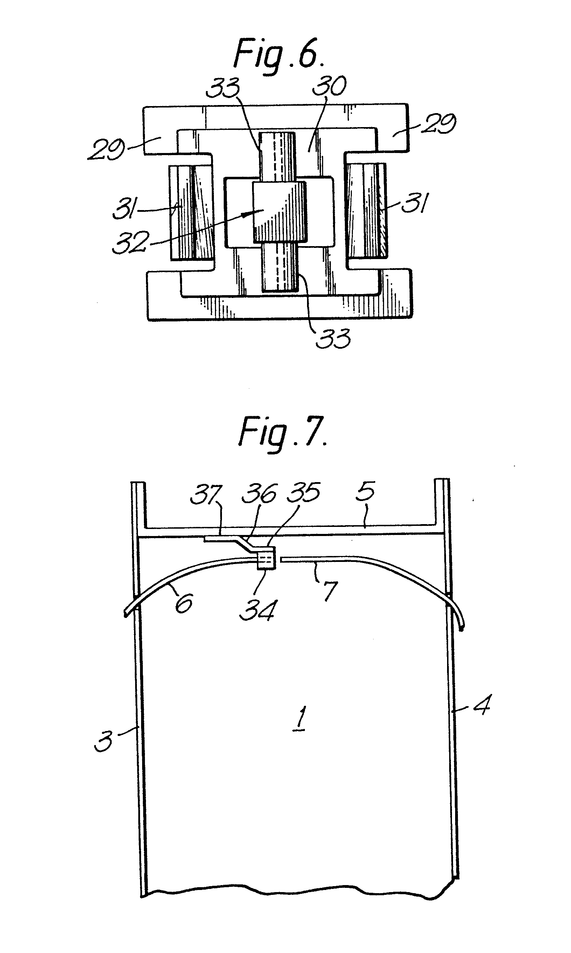

It will be appreciated that a large number of variations are possible for the detailed design of blade member 18. These can be arranged so that optical communication is permitted between fibres 6 and 7 when an electronic unit is correctly inserted into the tray 1, while preventing optical communication at other times (e.g. as shown in Figures 6a and 6d); or they can be arranged so that optical communication is broken when the electronic unit is correctly inserted into tray 1 (for example as shown in Figure 6c).

Figures 5 and 6 show another embodiment of blade unit which is generally similar in construction to the blade units shown in Figure 4. The embodiment of Figures 5 and 6, however, dispenses with biassing means such as coil spring 22 of Figure 6b and instead relies upon integral flexure of the blade construction. As shown in Figure 5, the blade unit includes a lower plate 28 formed with a channel designed to receive the ends of optic fibres 6 and 7. An intermediate plate member 29 carries a framework 30 which includes lugs 31 which are analogous to the lugs 16 shown in Figures 4a and 4b. Blade member 32 is formed integrally with arms 33 which are functionally equivalent to the arms 19 of Figure 4. The mode of operation of blade member 32 is analogous to that of blade member 18 as shown in Figure 4.

A further embodiment of the invention is shown in schematic plan view in Figure 7. In this embodiment, the end of optic fibre 6 is mounted in a shoe 34 carried on one end 35 of a leaf spring 36. The other end of spring 36 is secured at 37 to the rear face 5 of tray 1. As shown in Figure 7, opposing ends of fibres 6 and 7 confront one another, thereby permitting optical communication. The location of fibre 6 within shoe 34 can be chosen so that optical communication results when an incoming electronic unit acts against shoe 34 to move shoe 34 towards rear face 5 against the action of leaf spring 36; with such an arrangement, light can pass between fibres 6 and 7 when the electronic unit is correctly positioned, while optical communication is prevented in other circumstances since fibres 6 and 7 will no longer be in alignment.

In a preferred system utilising a tray in accordance with the invention, the proper insertion of an electronic unit can be assured in the following way, reference being made to Figures 1-3: the unit is

0184328

positioned initially on base plate 11 and is urged in the direction of rear face 5 (either manually or by means of a mechanical inserter/extractor hold-down). During this operation, a torch or other low power light source is directed at the free end of fibre 7 (see Figure 1). As the cconnector pins of the electronic unit mate with the connector plate adjacent to surface 5, the rear surface of the incoming electronic unit presses against shoulder 43, thereby causing the blade to pivot about axis 13. As a result, slot 14 becomes aligned with fibres 6 and 7, which are themselves in alignment. Thus a beam of light from the torch is able to travel down fibre 7 and to pass through slot 14 and enter fibre 6. Visual inspection of the free end of fibre 6 shows whether or not optical communication via slot 14 is occurring. The position of blade 10 and the dimensions of slot 14 are selected so that optical communication occurs only when the electronic unit is properly mated with its connector plate within the permitted tolerances.

Claims:                                                    0184328

1.    A  tray  for  mounting  an  electrical  or electronic unit, which tray includes an optical circuit including two light guides disposed such that, when the electrical or electronic box is correctly mounted on the tray, the optical configuration of said two light guides is  in  a  first  state,  while  when  an  electrical  or electronic box is incorrectly mounted in the tray, the optical configuration of said two light guides is in a second state distinguishable from said first state.

2.  A tray as claimed in claim 1, wherein said two light  guides  are  arranged  so  that  there  is  optical communication between them when said unit is correctly mounted on the tray, but no optical communication between them otherwise.

3.   A tray as claimed in claim 1 or 2, wherein said light guides are optic fibres.

4.   A  tray  as  claimed  in  claim  3,  wherein  said optic fibres are affixed to the tray close to the base thereof.

5.  A tray as claimed in any preceding claim, wherein the light.guides are disposed so that the action of  correctly  inserting  a  unit  brings  the  ends  of  the light guides into optical communication.

6.   A  tray  as  claimed  in  claim  1,  2,  3  or  4, wherein there is provided a mechanical device interposed between the ends of the light guides such that in one position  of  the  device  there  is  optical  communication between  the  light  guides  whereas  in  other  positions  of the device there is no optical communication between the

light guides.

7.   A tray as claimed in claim 6, wherein said device is a perforated or slotted blade.

8.   A tray as claimed in claim 6 or 7, wherein said device is mounted for linear motion.

9.   A tray as claimed in claim 6 or 7, wherein said device is mounted for pivotal motion.

10.  A tray as claimed in claim 6, 7, 8 or 9, wherein said device forms part of an element arranged to be inserted into a receiving slot formed in the tray.

11.  A tray as claimed in claim 5, wherein the end of one of the light guides is mounted in a shoe positioned on one end of a leaf spring the other end of which spring is secured to the tray in the vicinity of the connector plate for the electrical or electronic unit.

12.  A tray as claimed in any preceding claim, wherein the tray further comprises a light-detecting unit for determining whether or not there is optical communication between the light guides.

0184328

Fig.1.

Fig.3.

Fig.2.

2/3

0184328

Fig.5.

Fig.4a.

Fig.4c.

Fig.4b.

Fig.4d.

## Fig.6.

## Fig.7.

European Patent
Office

**EUROPEAN SEARCH REPORT**

0184328

Application number

EP  85 30 8014

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| Y | US-A-4 126 380  (BORM) <br> * Column 2, lines 26-53; figure 1 * | 1-4 | H 05 K    5/00 <br> G 02 B    6/04 |
| Y | FR-A-2 546 676  (VIBRACHOC) <br> *  Page 6, line 14 - page 7, line 8; figure 5 * | 1-4 | |
| A | DE-A-2 107 992  (FELTEN & GUILLEAUME) <br> * Page 4, paragraphs 3,4; figures 1-3 * | 2,3,6 | |
| A | PATENTS ABSTRACTS OF JAPAN, vol. 5, no. 175 (P-88) [847], 11th November 1981; & JP - A - 56 103 374 (TOKYO SHIBAURA DENKI K.K.) 18-08-1981 <br> * Abstract * | 3,6,7, 9 | |

TECHNICAL FIELDS
SEARCHED (Int. Cl.4)

H 05 K
H 01 R
H 01 H
G 02 B
G 01 D

The present search report has been drawn up for all claims

| Place of search | Date of completion of the search | Examiner |
|---|---|---|
| THE HAGUE | 14-02-1986 | TOUSSAINT F.M.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82